# EUROPEAN PATENT APPLICATION

(11) **EP 1 739 212 A1**
(43) Date of publication of application: **03.01.2007**
(21) Application number: 04728668.7
(22) Date of filing: 21.04.2004
(51) Int. Cl.: C30B 30/00

(54) **DROPPING PIPE TYPE GRANULAR CRYSTAL MANUFACTURING APPARATUS AND GRANULAR CRYSTAL MANUFACTURING METHOD**

(71) Applicant: Kyosemi Corporation, Kyoto-shi, Kyoto 612-8201 (JP)
(72) Inventor: NAKATA, Josuke;, Kyoto-shi, Kyoto, 6101102 (JP)
(74) Representative: Senior, Alan Murray
(86) International application number: PCT/JP2004/005735
(87) International publication number: WO 2005/103344

(57) **Abstract**

A drop tube type granulated crystal manufacturing device (1) for making a nearly spherical crystalline substance by instant solidification as the solidification trigger by impacting the inner wall surface of a drop tube while a granular droplet made of an inorganic material is discharged from a nozzle of a rotary crucible by the centrifugal force and allowed to free fall inside the drop tube, has been disclosed. The crucible (12) is provided at the upper end of the drop tube (4) and which holds melt of inorganic material and is capable of rotating around a vertical centeral axis, and a plurality of nozzles (23) of a small diameter formed in a radial pattern relative to the vertical centeral axis, is formed at the periphery of the crucible (12). The crucible (12) is rotatively driven by the rotary drive means (13), and the crucible (12) and inorganic material held in the crucible (12) is heated by a heating means (15) and a cooling gas flow is formed inside the drop tube (4) by the gas flow formation means (5).

## Description

### TECHNICAL FIELD

The present invention relates to a drop tube type granulated crystal manufacturing device and granulated crystal manufacturing method that create a nearly spherical crystal body by solidifying while a granular droplet of an inorganic material is allowed to free-fall through the inside a drop tube, and especially relates to technology for making granulated crystal from granular droplets discharged by centrifugal force from a plurality of nozzles formed into a crucible.

### BACKGROUND OF THE RELATED ART

United States Patent Publication 4,322,379 describes technology for producing substantially uniform size tear-shaped crystals by heating semiconductor silicon to melt within the upper end of a drop tube made of quartz, and applying a gaseous pressure of helium gas to the melt for solidification during free fall. However, this does not achieve a sufficient microgravity state due to the drop resistance by the gas inside the drop tube.

The following drop tube type manufacturing technology for drop tube type granulated crystal is described in "Development and Evaluation of the Texas Instruments Solar Energy System" 16th IEEE PVSC Proceedings P. 257 through P. 260 (1982). In other words, silicon spherical crystal is manufactured by melting silicon by a crucible provided at the upper end of a shot tower; applying gaseous pressure of helium gas to the melt within the crucible; discharging the melt gradually to the lower end from a small diameter nozzle formed at the bottom of the crucible; and allowing the droplets to free fall through inert gas within the shot tower.

Such production technology is known as jet atomization, wherein rapid solidification occurs in gas, the crystal granularity becomes a small polycrystalline substance, and a crystal granularity range of about 500 µm of the maximum diameter can be manufactured, although a larger size spherical shaped crystal is difficult to manufacture.

On the other hand, an inorganic material is melted in a crucible in the method for the manufacture of spherical particles from the melt proposed in United States Patent 5,183,493, and gas pressure is applied to the melt; vibration is applied to a nozzle while the melt is dropped from the narrow nozzle formed at the bottom of the crucible; the melt is discharged in increments; and the droplets are solidified by allowing them to free fall within the drop tube. However, a spherical crystal having a uniformed particle diameter is difficult to manufacture in any one of the above methods because, not only does the amount of gaseous pressure applied to the melt and the amount of vibration energy applied to the nozzle fluctuate according to the quantity of melt in the crucible, any temperature change, and the pressure of the gaseous atmosphere, but it is also influenced by these.

In addition, a downward acceleration force is applied to the droplets from the beginning, so the droplets are susceptible to the resistance of atmospheric gas during the free fall, lessening the effect of reducing the action of gravity by the free fall. Subsequently, there is a problem to forming a single crystal because the droplets are chilled instantly from the surface as soon as the are being discharged from the nozzle. Further, a spherical crystal is difficult to obtain with a 1mm-diameter droplet because solidification of the centeral portion is delayed in comparison with the surface of the droplet, and the melt portion where the solidification is delayed is solidified on the surface of a crystal as a tail-shaped projection. Furthermore, a spherical crystal is difficult to mass produce, and lowering the manufacturing cost is difficult due to allowing droplets to fall sequentially from one nozzle.

The inventor of the present invention, as shown in Japanese Patent No. 3231244, has disclosed a method to obtain a spherical single crystal where, in forming a spherical single crystal by making droplets by melting semiconductor particles in a suspension and allowing the droplets to free fall by a drop tube type spherical crystalline substance manufacturing device, the temperature of the surface is increased by heating the droplets instantly immediately after the fall, and the interior and surface of the droplets can be solidified simultaneously, or the interior first.

Further, the inventor of the present application also also disclosed a method for a manufacturing device of a single crystal in Japanese Patent No. 3287579, to obtain a single crystal by allowing a spherical droplet during the free fall in a super-cooled state, and accomplishing a solidification trigger for generating a crystal nuclei by point contacting a solid surface with one point of a droplet. Manufacturing a granulated single crystal of a uniform size effectively has been difficult in even this manufacturing device.

Furthermore, the inventor of the present application discloses a technology in a drop tube spherical crystalline substance manufacturing device proposed in the International Publication WO03/095719, in which droplets are allowed to drop downward from the tip of a nozzle by applying vertical vibration to a crucible where the melt is held by a vibration device, and cooling gas for chilling the droplets during the fall is flows down in the same direction with the falling direction of droplets.

However, it is also difficult for this spherical crystalline substance manufacturing device to mass produce a spherical crystal efficiently because the number of droplets that can be dropped per unit of time is few.

The object of the present invention is to provide a device and a method that enables efficient manufacture of granulated crystals of a uniform size. Another object of the present invention is to provide a device and method that enables the manufacture of granulated crystals of a high quality single crystal. A further object of the present invention is to provide a granulated crystal manufacturing device that enables lower equipment cost, and to provide a granulated crystal manufacturing device that enables reduced consumption in cooling gas is also provided.

### SUMMARY OF THE INVENTION

A drop tube type granulated crystal manufacturing device according to the present invention is a drop tube type granulated crystal manufacturing device for creating a nearly spherical crystalline substance by solidifying while allowing a granular droplet made of an inorganic material to free fall within a drop tube, comprising: a crucible provided at an upper end portion of said drop tube and rotatable around a vertical central axis, said crucible having a plurality of nozzles of a small diameter formed in a radial pattern relative to said vertical centeral axis at a periphery area thereof, and said crucible holding a melt of said inorganic material; a rotary drive means for rotatively driving said crucible; a heating means for heating said crucible and said inorganic material held in said crucible; and a gas flow formation means for forming a flow of cooling gas inside said drop tube.

When manufacturing a nearly spherical crystalline substance made of an inorganic material (for instance, semiconductor), raw material of an inorganic material is held in the crucible, and a gas flow of cooling gas that flowing, for instance downward, through the inside of the drop tube is formed by the gas flow formation means. Then, the crucible and the inorganic material within the crucible are heated by the heating means, and the crucible is driven to rotate by the rotary drive means a nearly spherical crystal is formed by allowing droplets of inorganic material to be discharged from a plurality of small-diameter nozzles formed in the crucible in a horizontal, or a nearly horizontal, direction and to drop into the drop tube by the centrifugal force overcoming the surface tension, and granular droplets are solidified by cooling gas while the droplets maintain a spherical shape due to the affect of surface tension during the free fall within the drop tube.

When a velocity of gas flow of cooling gas is set to be equal with the velocity of the free fall, the resistance from the atmospheric gas has no effect on the droplets during the free fall, and the droplets keep falling while maintaining a spherical shape due to the surface tension affect, and then become in a super cooled state by being chilled by the cooling gas. Subsequently, droplets in the super cooled state contacts the inner surface of the lower part of the drop tube, and the contact becomes a trigger for creating the nucleus of a single crystal in a droplet, and then the droplet is instantly solidified and becomes a single crystal.

According to the granulated crystal manufacturing device, the following effects are obtained.
(1) Droplets can be discharged from nozzles without applying a force other than gravity to the droplets in the vertical downward direction because the granular droplets are discharged from a plurality of nozzles in the crucible in a horizontal or a nearly horizontal direction by the affect of centrifugal force. Therefore, the acceleration and the velocity of free fall can be decreased, and the cooling time can be made longer or the length of the drop tube can be shortened. Further, the difference in the diameter of the spherical crystal can be reduced because droplets are discharged from the crucible by centrifugal force against the surface tension.
   In addition, not only can the diameter of the crystal be changed by changing the rotating speed in rotating the crucible by the rotary drive means, but also the number of single crystals produced per unit of time can be easily increased by changing the rotating speed by the rotary drive means and changing the number of nozzles and their diameter by replacing the crucible.
(2) When a cooling gas flow is created in the drop tube by the gas flow formation means and droplets are allowed to fall through the drop tube with the cooling gas flow, each of droplets are solidified into a single crystal while maintaining a spherical shape by the surface tension affect because droplets fall freely without the resistance of the atmospheric gas.
   This has the advantage of making a granulated crystal manufacturing device because the cooling rate to chill the droplets can be increased, the amount of time required until solidification can be reduced, and the length of the drop tube can be shortened because droplets are solidified by allowing them to fall while being chilled by cooling gas, and also there is no need to create a vacuum inside the drop tube.
(3) Crystals can be efficiently mass produced because granular droplets can be discharged nearly consecutively (intermittently) from a plurality of nozzles in the crucible by consecutively supplying inorganic material from a raw material feeder into the crucible, and melting it by heating.
(4) When providing a post-phase heating means for preventing the instant cooling of droplets during the fall inside the upper end portion of the drop tube besides the above mentioned heating means, instant cooling of the granular droplets can be prevented, as well as the formation of a tail-shaped projection on the crystal at the time of droplet solidification.

The following various constitutions may be adopted additionally in the present invention.
(a) Providing a post-phase heating means for preventing instant cooling of granular droplets during the free fall inside the upper end portion of the drop tube besides the above heating means.
(b) Forming a cooling gas flow directing from top to bottom inside the drop tube with a velocity nearly equal to the velocity of free falling droplets discharged from nozzles by the gas flow formation means.
(c) Providing a level detection means for detecting the level of the melt within the crucible.
(d) Providing a melt temperature detection means for detecting the temperature of the melt within the crucible, and a temperature control means for controlling the temperature of the melt within the crucible based on the detected signal of the melt temperature detection means.
(e) Providing a rotating speed detection means for detecting the rotating speed of the crucible.
(f) Providing an external passage that are connected in parallel to the drop tube and a gas circulating pump in the gas flow formation means.
(g) Providing a circular gas induction chamber which is connected to the external passage, for introducing cooling gas from the external passage, and a circular gas induction passage for communicating the gas induction chamber and the upper end of the drop tube.
(h) Providing a collecting unit at the lower end side of the drop tube, for collecting the crystals solidified in the drop tube.
(i) Forming a cooling gas passage inside the drop tube so that the cross sectional area becomes smaller toward the downward side.
(j) Forming an inner peripheral surface of the drop tube with a curved surface that moves towards the vertical centeral axis toward the downward side.
(k) Providing a cooling device for cooling the cooling gas in the gas flow formation means.
(l) The inorganic material is a semiconductor.
(m) The cooling gas is helium gas, argon gas, or mixed gas of these two.
(n) Providing a pressure and temperature adjusting means, for adjusting the gas pressure and the temperature of the cooling gas inside the drop tube in the gas flow formation means.
(o) Providing a raw material feeder for consecutively supplying raw material to the crucible.
(p) Providing a control means capable of controlling the rotating speed of the crucible which is driven to rotate by the rotary drive means, for changing the diameter of a droplet discharged from the crucible.
(q) The control means controls the rotary drive means so as to discharge droplets from nozzles by increasing the rotating speed of the crucible pulsatively at intervals of pre-determined short time.
(r) Providing a pressurization means or vibration means capable of applying minute pressure to the melt within the crucible, and a pressurization control means for controlling the pressurization means or vibration means so that droplets are discharged from nozzles by applying minute pressure to the melt within the crucible at intervals of pre-determined short time by the pressurization means or the vibration means.
   A granulated crystal manufacturing method for making a nearly spherical crystalline substance by solidification while allowing granular droplets of inorganic material to free fall inside a drop tube, comprising: a first step for melting a raw material of inorganic material in a crucible which rotating said crucible provided at an upper end portion of said drop tube around a vertical axis; a second step for allowing granular droplets to fall inside said drop tube by extracting said granular droplets to a horizontal or nearly horizontal direction by a centrifugal force, from a plurality of nozzles of a small diameter which are formed in a radial pattern relative to said vertical axis at a peripheral area of said crucible; and a third step for solidifying said granular droplets during free fall inside said drop tube.
   The following constitutions may be adapted in addition to the above granulated crystal manufacturing method.
(s) Cooling gas flows inside the drop tube in the same direction as the melt at a nearly equal velocity to the falling velocity of the granular melt in the second step.
(t) The melt is solidified by chilling the melt until a super cooled state during the free fall of the granulated melt and making the droplet contact with the peripheral wall of the drop tube.

### BRIEF DESCRIPTION OF THE DRAWINGS

FIG. 1 is a cross-sectional view of the granulated crystal manufacturing device according to an embodiment of the present invention.
FIG. 2 is an enlarged cross-sectional view of the crucible.
FIG. 3 is an enlarged cross-sectional view of a nozzle section in the crucible.
FIG. 4 is a cross-sectional view along IV - IV line of FIG. 2; and FIG. 5 is a cross-sectional view of the granulated crystal manufacturing device according to a modified embodiment.

### DETAILED DESCRIPTION OF THE PREFERRED EMBODIMENTS

A preferred embodiment of the present invention is described hereafter with reference to the drawings. This drop tube type granulated crystal manufacturing device melts a raw material of inorganic material in a rotary crucible, and discharges the granular melt in a horizontal or nearly horizontal direction from a plurality of nozzles of a crucible, and allows the granular droplets to free fall inside the drop tube with a cooling gas flow, and solidifies the droplets of a super cooled state instantly by contacting the internal wall of the drop tube, and a nearly spherical crystalline substance consisting of a single crystal of inorganic material is manufactured continuously. In addition, the size of a nearly spherical crystalline substance has a diameter of about 600 through 1,500 µm.

A p-type or n-type silicon semiconductor is used as a semiconductor for the inorganic material in the present embodiment, and an explanation is provided by using the drop tube granulated crystal manufacturing device 1 for manufacturing a nearly spherical crystalline substance of a silicon single crystal as an example. However, the following explanation includes the explanation of the granulated crystal manufacturing method.

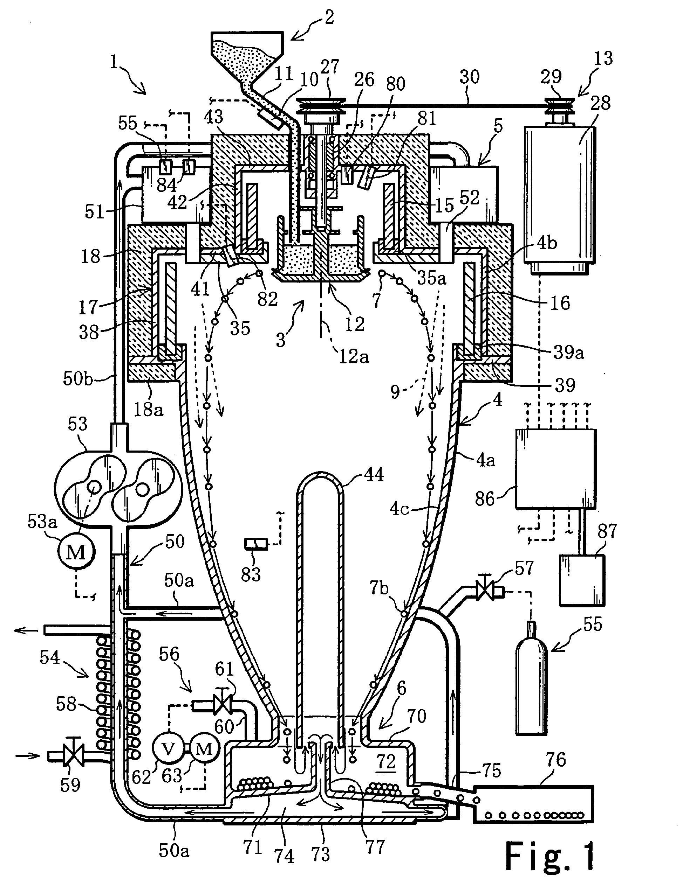

As shown in FIG. 1, the granulated crystal manufacturing device 1 comprises a raw material feeder 2 for supplying raw material of silicon; a droplet forming mechanism 3 for melting the raw material and creating a granular droplet by a fixed quantity from the melt, and discharging it; a drop tube 4 (fall tube); a gas flow forming mechanism 5 for forming the flow of cooling gas from top to bottom within the drop tube 4; and a collection mechanism 6 that is connected to the lower end side of the drop tube 4, or the like.

The raw material feeder 2 holds powdered polycrystal silicon or granulated raw material, and provides continuous supply to a crucible 12 from a supply tube 11 by applying vibration by a vibrator 10 at a pre-determined supply rate a little at a time.

The droplet forming mechanism 3 will be described next.

The droplet forming mechanism 3 comprises the crucible 12 made of quartz which creates melt by melting raw material of silicon; a rotary drive means 13 for supporting and driving rotatively the crucible 12; a stainless-steel circular plate 35 for forming a top wall of the drop tube 4; a first cylinder shaped graphite heater 15 for heating the crucible 12 and the raw material held therein; a second cylinder shaped graphite heater 16 for heating the droplet 7 discharged from a plurality of nozzles 23 of the crucible 12; a stainless-steel heat shielding case 17 for covering the exterior of the first and second graphite heaters 15 and 16; and a heat insulation member 18 for insulating the outer peripheral area of the heat shielding case 17.

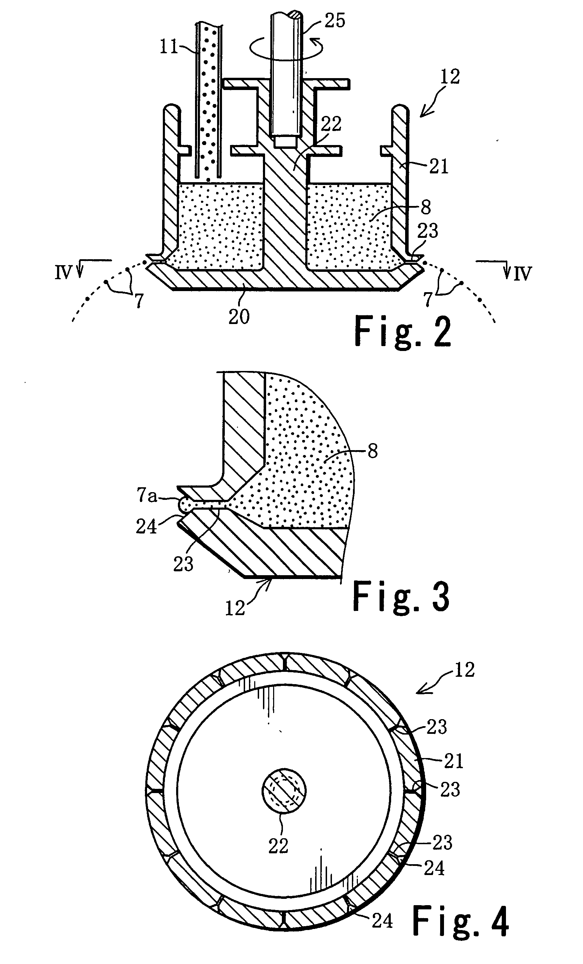

As shown in FIG. 2 through FIG. 4, the crucible 12 is made of quartz glass capable of rotating around the vertical centeral axis 12a, and for instance, the inner diameter is about 40mm, and the capacity is 650cc. The crucible 12 comprises a bottom wall 20, a peripheral wall 21; a central axis portion 22; and twelve nozzles 23 that are formed at the lower part of the peripheral wall 21. The twelve nozzles 23 of a small diameter are formed radially in the horizontal direction at every even interval of the circumferential direction relative to the vertical centeral axis 12a. Construction is such that the crucible 12 is driven to rotate with a predetermined rotating speed, and the melt 8 of silicon within the crucible 12 becomes a droplet 7 of a pre-determined size discharged from nozzle 23 by centrifugal force against surface tension.

As shown in FIG. 3, the diameter of the nozzle 23 is, for instance, 0.3 through 1.0 mm, and a V shaped concave section 24 having an opening angle of about 90-degree is formed at the tip side of the nozzle 23, so the melt portion 7a which is raised at the tip of the nozzle 23 by the intermolecular attraction acting between the surface of the concave section 24 and the silicon melt 8, is easily formed.

The rotary drive means 13 for rotatively driving the crucible 12 will be described hereafter.

As shown in FIG. 1 and FIG. 2, a drive shaft 25 extending upwards is fixed at the central axis portion 22 of the crucible 12, and the drive shaft 25 is held rotatably through a bearing 26 at a top plate portion 43 of the heat shielding case 17 and the heat insulation member 18. A pulley 27 is fitted at the upper end of the drive shaft 25, and is coupled and connected to a pulley 29 of the output shaft of an electric motor 28 by a timing belt 30. A stepping motor is applied in the present embodiment as the electric motor 28; however, other various motors may be adopted.

The first graphite heater 15 heats the crucible 12 and the raw material within the crucible 12 up to the melting temperature (about 1450 ~ 1469 °C for silicon) by the resistance heat of high purity graphite coated by SiC, and the first graphite heater 15 is provided so as to surround the periphery of the crucible 12, and is held by engaging to an dielectric ring 35a made of ceramic which is fixed at the circular plate 35, with power being supplied to the electrode from an electrical supply wire (not shown). Here, the zone heated by the first graphite heater 15 is the heat melting zone. The second graphite heater 16 has construction similar to the first graphite heater 15, and is provided so as to face the inside of the drop tube 4 at the exterior side of the upper end part of the drop tube 4, and the second graphite heater 16 is held by engaging with an dielectric ring 39a made of ceramic which is fixed at a guard plate 39 at the upper end of the drop tube main body 4a. Power is supplied to the electrode of the heater 16 from an electrical supply wire (not shown). The second graphite heater 16 heats the plurality of droplets 7 during the free fall through the upper end portion of the drop tube 4 so that the droplets 7 discharged radially from the crucible 12 are not chilled quickly by cooling gas flowing downward within the drop tube 4. The zone heated by the second graphite heater 16 is the buffer zone, by which the the peripheral wall of the upper part of the drop tube 4 is formed.

The heat shielding case 17 is a cylinder portion 38 that covers the periphery of the second graphite heater 16, and is externally fitted to the dielectric ring 39a by placing on the guard plate 39 of the upper end of the drop tube main body 4a; a circular portion 41 which abuts the upper surface of the circular plate 35; a cylinder portion 42 covering the peripheral side of the first graphite heater 15; and a top plate portion 43 which blocks the upper end of the cylinder portion 42. The heat insulating member 18 made of, for example, silica wool, and the external surface of the heat shielding case 17 is covered by the heat insulating member 18 of a pre-determined thickness, and the lower surface of the guard plate 39 is also covered by the heat insulating member 18a. Maintenance or the exchange of the crucible 12 are possible by detaching the whole of the droplet forming mechanism 3 upwards because the cylinder portion 38 of the heat shielding case 17 is constructed so as to be detached relative to the guard plate 39.

Next, an explanation will be made on the drop tube 4.

As shown in FIG. 1, the drop tube 4 is a tube of, for instance, a long narrow cylindrical shaped stainless steel plate, and the length of the drop tube 4 is about 4 through 6 m. The drop tube 4 is constructed so that the cross-sectional area becomes smaller toward the downward side so as to make the flow velocity of cooling gas (argon gas) nearly equal to the free fall velocity of the granular droplet 7. The inner surface of the drop tube 4 is formed on the curved surface which becomes closer to the vertical centeral axis 12a toward the downward side, and the falling trajectory of the discharged droplet 7 that free falls from the nozzle 23 of the crucible 12 and the inner wall surface 4c of the drop tube 4 intersect at an acute angle of about 10 through 20 degrees in the cross-sectional view of FIG. 1.

The lower end of the drop tube 4 is integrally connected to the upper case plate 70 of the collection mechanism 6. A stainless steel flow velocity adjustor member 44 for increasing the flow velocity of the cooling gas by making the cross-sectional area of the drop tube 4 smaller is provided at the central area of the lower interior part of the drop tube 4, the flow adjustor member 44 being constructed so that the upper end of the tube body is closed by a semisphere piece. In addition, the shape of the flow adjustor member 44 may be suitably modified.

The shape of the drop tube 4 is set so that the droplet 7 discharged from the nozzle 23 of the crucible 1 falls freely within the drop tube 4, and the droplet 7 can gradually approach and make solid contact with the inner wall surface 4c at the lower part of the drop tube 4. The granular droplet 7 discharged from the droplet forming mechanism 3 is cooled by the cooling gas flow 9 during free fall inside about 2/3 part of the upper side of the drop tube 4 while maintaining a spherical shape by the action of surface tension as well as being cooled to a super cooled state by radiation cooling. A crystalline nucleus of a single crystal is generated within the droplet 7 by the pressure created when the droplet 7 in a super cooled state makes contact with the inner wall surface 4c at the lower part of the drop tube 4, and which becomes the crystalline substance 7b of a spherical single crystal by the instantaneous crystal growth which starts from the crystalline nucleus.

Next, an explanation will be made on the gas forming mechanism 5.

The gas forming mechanism 5 is for forming the cooling gas flow 9 occurring from top to bottom inside the drop tube 4 in order to have the droplet 7 free fall without resistance from the gas affecting the droplet 7 discharged from the crucible 12.

The gas forming mechanism 5 comprises an external passage 50 connected in parallel to the drop tube 4; a circular tank passage 51 placed on the shoulder of heat insulating member 18; a circular slit passage 52 which extends from the lower end of the circular tank passage 51 to the upper end of the drop tube 4; a gas circulation pump 53 provided at the midway of the external passage 50; a gas cooler 54 for cooling the cooling gas; a gas charging cylinder 55 for charging cooling gas; and a gas pressure regulating means 56 for regulating the gas pressure of the cooling gas inside the drop tube 4.

The circular tank passage 51 is constructed from, for instance, a stainless steel plate so as to form a large capacity tank and the upper end of the external passage 50 is connected to this circular tank passage 51. The circular slit passage 52 is continuous throughout the entire circumference and is also connected to the outer periphery of the upper end of the drop tube 4. Therefore, the cooling gas flow 9 of a thick gaseous curtain that flows downward along the vicinity of the inner wall 4c of the drop tube 4, is formed by cooling gas delivered into the drop tube 4 from the circular slit passage 52.

The external passage 50 comprises a plurality of lower passages 50a and upper passages 50b connected to their upper end, and a gas circulation pump 53 is provided at the upper passage 50b. When there is a need for filling cooling gas, an on-off valve 57 is opened and argon gas is filled into the lower passage 50a from the cylinder 55.

The temperature of cooling gas increases gradually while the crystalline substance manufacturing device 1 is used, so a gas cooler 54 is provided for chilling the cooling gas. The gas cooler 54 (a temperature regulator means for cooling gas) comprises a cooling water tube 58 and an on-off valve 59 that are externally filled at one lower passage 50a, and the cooling water cooled tube 58 is connected to the water supply system for supplying cooling water. The gas cooler 54 is utilized so as to maintain the temperature of the cooling gas at a pre-determined temperature (about 20 through 30 °C).

A pressure regulator 56 (a pressure regulator means) is provided for regulating the gas pressure of cooling gas inside the drop tube 4. The pressure regulator 56 comprises a suction tube 60 which is continuously connected through a collection chamber 72 within the upper case plate 70 of the collection mechanism 6; an on-off valve 61; a vacuum pump 62 and its drive motor 63. Pressure regulator 56 is used even when the air inside the drop tube 4 is replaced with cooling gas when initializing the crystalline substance manufacturing device 1.

An explanation is provided next of the collection mechanism 6 for recovering the crystalline substance 7b.

The collection mechanism 6 comprises a collection chamber 72 for recovering the crystalline substance 7b encompassed by the upper case plate 70 and a middle case plate 71; a gas collection chamber 74 encompassed by the middle case plate 71 and a bottom case plate 73; an extraction passage 75 for extracting the crystalline substances 7b to the collection chamber 72, and a collection box 76 connected to the extraction passage 75: A tube 77 is integrally raised up to the center within the bottom portion of the drop tube 4 from the middle case plate 71, and the flow velocity adjustor member 44 is raised from the vicinity of the upper part of the tube 77 until the inner space of the lower half part of the drop tube 4. The bottom end of the flow velocity adjustor member 44 is connected to the middle case plate 71 by, for instance, four-plate member (not shown).

Next, an explanation is provided of sensors and the control system.

As sensors, provided are a supersonic sensor 80 for detecting the fluid level of the melt 8 within the crucible 12; an infrared radiation sensor 81 for detecting the temperature of the melt 8 within the crucible 12; an infrared radiation sensor 82 for detecting the temperature of the droplet 7 immediately after discharged from the nozzle 23 of the crucible 12; an infrared radiation sensor 83 for detecting the temperature of the droplet 7 of colliding area to inner wall surface 4c of the drop tube 4; a thermistor temperature sensor 84 for detecting the temperature of cooling gas within the circular tank passage 51; and a pressure sensor 85 for detecting the pressure of cooling gas, and sensor detection signals are sent to the drive control unit 86.

The vibrator 10, the electric motor 28 of the rotary drive means 13, the first and second graphite heaters 15, 16, and drive motor 53a of the gas circulation pump 53, and the drive motor 63 for driving the vacuum pump 62, are also controlled by the drive control unit 86.

The drive control unit 86 comprises a control unit including a computer and a driving unit including a plurality of driving circuits for a plurality of electric actuators (11, 15, 16, 28, 53a, and 63), and the control program for controlling those electric actuators are input and stored in the computer of the control unit in advance. Also an operation panel 87 is connected to the drive control unit 86.

An explanation is provided of the operation and effect of the drop tube type granulated crystal manufacturing device 1.

By means of withdrawing the air within the drop tube 4, the external passage 50, and the circular tank passage 51 by the vacuuming pump 62 while supplying argon gas from the gas charge cylinder 55 before starting to use the crystalline substance manufacturing device 1, the air within the drop tube 4 is replaced with cooling gas (argon gas), and the gas pressure of the cooling gas within the drop tube 4 is made to be a pre-determined pressure of about atmospheric pressure. Subsequently, silicon raw material is supplied to the crucible 12 from the raw material feeder 2, the gas circulation pump 53 is operated, heating is started by supplying a power current to the first and second graphite heaters 15 and 16, and then the crucible 12 commences rotation at a pre-determined low speed in the range of 1 through 300 rpm by the electric motor 28 after most of the silicon raw material is melted. When the temperature of the melt 8 within the crucible 12 reaches pre-determined temperature in range of 1450 through 1460 °C, the rotation rate of the crucible 12 is switched to gradually increase the speed, which becomes a suitable rotation rate in the range of 300 through 6000 rpm. Cooling gas is pressurized by the gas circulation pump 53, and circulated chronologically from the external passage 50, circular tank passage 51, inside the drop tube 4, gas collection chamber 74, and the external passage 50, and which flows downward side inside the drop tube 4, along the vicinity of the inner wall surface 4c of the drop tube 4, and becomes a gas curtain flow having a thickness with a faster flow velocity toward the downward upon which melt portion 7a which is swelled by the centrifugal force and the head pressure of the melt is formed at the tip end of each nozzle 23 of the crucible 12, and is radially discharged in the horizontal direction as the droplet 7 at the moment when the centrifugal force becomes larger than the surface tension, and falls downwards within the drop tube 4.

When discharging of the droplet 7 begins from the plurality of nozzles 23, the rotating speed of the crucible 12 may be maintained at the value or a little faster rotating speed than the value. Immediately after discharging the droplet 7, the next melt portion 7a swells at the tip of the nozzle 23 and is discharged as the droplet 7, so the droplet 7 is discharged from each nozzle 23 sequentially and intermittently at intervals of pre-determined short time. In addition, because the intermolecular attraction from the surface of the concave portion 24 of the tip of nozzle 23, also affects the melt portion 7a swelled at the tip of the nozzle 23, the droplet 7 is discharged when the affect of the centrifugal force becomes larger than the intermolecular attraction and the surface tension.

Here, cooling gas flows downward at nearly the same velocity as that of the granular droplet 7 when the granular droplet 7 free-falls inside the drop tube 4 because the cross-sectional area of the drop tube 4 is sharply reduced towards the downward side so that the flow velocity of cooling gas can be nearly equal to the free-fall velocity of the droplet 7. Therefore, the relative velocity between the free fall of the droplet 7 and the cooling gas is scarcely generated, so the granular droplet 7 is effectively cooled by cooling gas and the external force has little affect on the droplet 7 from the cooling gas. Therefore, when the droplet 7 free-falls through the droplet tube 4, it falls while maintaining a nearly spherical shape due to the affect of surface tension because the droplet falls while maintaining a microgravity state by the free fall without being influenced by the force of gravity and external forces. The droplet 7 is cooled until a super cooled state before the spherical droplet 7 reaches the middle part of the drop tube 4.

The droplet 7 in the super cooled state falls and tangentially collides to the nearly vertical inner wall surface 4c of the drop tube 4 in the lower part of the drop tube 4. The impact of the collision becomes the solidification trigger, and a crystalline nucleus of a single crystal is generated at the point of the droplet 7, and the droplet 7 releases the solidifying latent heat at once, and a single crystalline substance is grown and solidified instantly in a recalescent phenomenon, and a nearly spherical crystalline substance 7b of a silicon single crystal falls into the collection chamber 72, the bottom surface of which is formed with an inclination downward towards the extraction passage 75. Therefore, the crystalline substance 7b within the collection chamber 72 sequentially flows into the extraction passage 75 and is recovered by the collection box 76.

When increasing the rotation rate of the crucible 12, the diameter of the droplet 7 becomes smaller while maintaining the fluid level and the temperature of the melt 8 within the crucible 12 in a constant state and the quantity of production per unit time of the crystalline substance 7b is increased. Further, when the rotating speed of the crucible 12 and the temperature of the melt 8 within the crucible 12 are maintained in a constant state, and the fluid level of the melt within the crucible 12 is increased by adjusting the raw material supply rate from the raw material feeder 2, the head pressure of the melt increases and the diameter of the droplet 7 becomes smaller.

In addition, modifications to the diameter and capacity of the crucible 12, and the number of nozzles, length and diameter of the nozzles 12 are possible by changing the crucible 12, thereby obtaining a similar effect to increasing the rotation speed of the crucible 12.

When there is a need for lowering the temperature of the cooling gas due to the detection of the temperature of the droplet 7 based on the detected signal of the infrared temperature sensor 82, the cooling capacity of the gas condenser 54 is increased. Further, when the falling velocity of the droplet 7 is faster than the free falling velocity, the drive motor 53a is controlled to decrease the rotating speed of the gas circulation pump 53 because the falling velocity of the droplet 7 can be calculated in conjunction with a pre-determined program by using detected signals of the infrared temperature sensors 82 and 83.

As explained above, the following effects can be obtained according to the granulated crystalline substance manufacturing technology. A droplet 7 can be discharged from the nozzle 23 without affecting forces other than gravity on the droplet because the droplet 7 is discharged in the horizontal direction by the affect of a centrifugal force from a plurality of nozzles 23 of the crucible 12. Therefore, the falling acceleration and the falling velocity of a droplet can be decreased. Accordingly, the falling time in which the droplet 7 falls in the drop tube 4 of a pre-determined length, becomes longer, so the cooling time can be longer, or the length of the drop tube 4 can be shortened. Furthermore, the diameters difference of the spherical crystalline substance 7b can be reduced because the droplet 7 is discharged from the nozzle 23 of the crucible 12 by centrifugal force against the surface tension. Not only can the diameter of the crystalline substance 7b be changed by changing the rotating speed of the crucible 12, but also the diameter and the number of nozzles 23 can be changed by changing the crucible 12, the size of the crystalline substance 7b can be changed by changing the rotation speed of the crucible 12 by the rotary drive means 13, and the quantity of production of the crystalline substance 7b per unit time can be easily increased.

Droplet 7 is solidified into the crystalline substance 7b of a single crystal while maintaining the spherical shape by the affect of the surface tension because cooling gas flow 9 directing downward is generated within the drop tube 4 by the gas flow formation mechanism 5, the droplet 7 falls with the cooling gas, and the droplet 7 falls freely without the influence of resistance from the cooling gas flow 9.

Accordingly, the present invention has an advantage in manufacturing the granulated crystal manufacturing device 1 because the droplet 7 falls while being cooled by the cooling gas flow 9, so the cooling rate to cool the droplet 7 can be increased, the required time until the solidification can be reduced, and the length of the drop tube 4 can be shortened. Moreover, there is no need for vacuuming inside the drop tube 4.

The crystalline substance 7b of a single crystal can be mass produced efficiently because the granular droplet 7 can be discharged nearly sequentially (intermittently) from the plurality of nozzles 23 of the crucible 12 by supplying raw silicon into the crucible 12 from the raw material feeder 2 and melting it by heating. The instant cooling of the droplet 7 can be prevented and the forming of a tail-shaped projection to the crystalline substance 7b can be prevented at the time of solidification of the droplet 7 because, besides the first graphite heater 15, a second graphite heater 16 is provided for preventing the instant cooling of the droplet 7 during the free fall inside the upper part of the drop tube 4.

Furthermore, the amount of consumption of cooling gas can be reduced due to the circulation of cooling gas, and the gas pressure of cooling gas within the circular tank passage 51 can be stabilized and the cooling gas flow within the drop tube 4 can be stabilized because the pressure, temperature, and the charging amount of cooling gas are controllable.

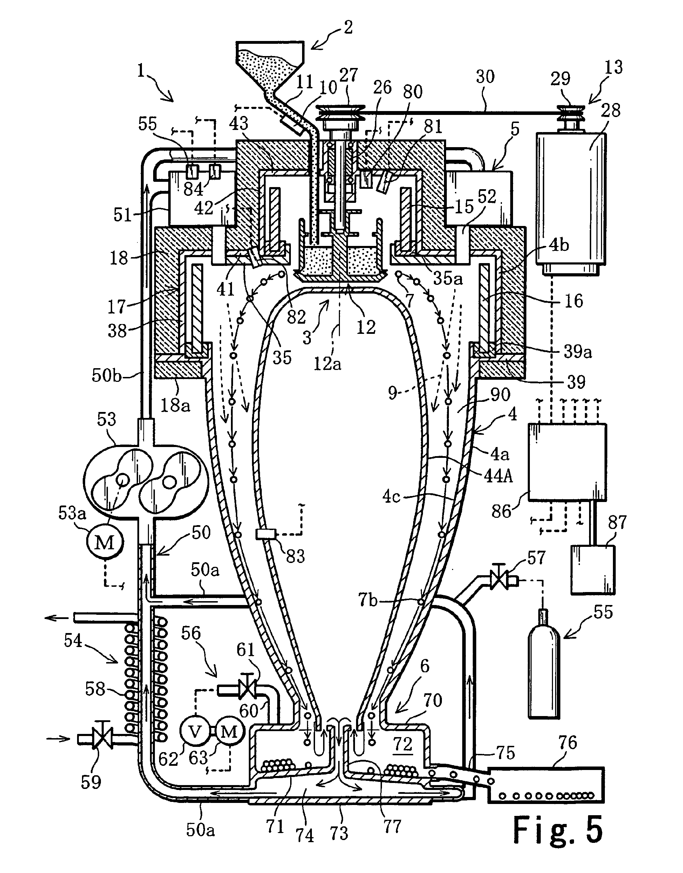

An explanation is provided hereafter of modified examples for partially changing the aforementioned embodiment.
1) The crucible may be constructed with graphite, silicon nitride, or other ceramic materials.
2) Nitrogen gas, helium gas or mixed gas of these two may be used for the cooling gas.
3) The electric motor 28 may be controlled so that the droplet 7 is discharged by increasing the centrifugal force which affects the melt portion 7a swelled at the tip of the nozzle 23 by increasing the rotating speed of the crucible 12 pulsatively at intervals of pre-determined short time.
4) A construction may be made to discharge the droplet 7 by providing a pressurization means or vibration means that is capable of applying minute pressure to the melt of the crucible 12, and a pressurization control means for controlling the pressurization means or vibration means, and in order to discharge the melt, pulsative pressure is exerted to the melt 8 at intervals of pre-determined short period by controlling the pressurization means or vibration means by the pressurization control means. Or, a construction may be made to discharge the droplet 7 by providing a vibration means capable of applying minute vertical vibration to the driving axle 25, and applying the vertical vibration to the driving axle 25 at intervals of pre-determined short period by the vibration means.
5) The aforementioned droplet formation mechanism 3 is shown just as an example, and a mechanism for generating the granulated droplets by melting an inorganic material by resistance heating, infrared concentration heating, plasma, or laser beam, and droplet formation mechanisms having other heating mechanism may be applied.
6) The height of the drop tube 4 is preferred to be constructed with the ability to change according to the size of the crystalline substance 7b.
7) Besides the crystalline substance 7b of the aforementioned semiconductor silicon; this technology may be applied to the manufacture of a single crystalline substance of a semiconductor such as germanium, InSb, GaSb, or other semiconductors.
   Further, crystalline substances of various inorganic materials besides semiconductors can be manufactured. As various inorganic materials, a dielectric substance, magnetic substance, insulating substance, fluorescent substance, fluoride crystal such as CaF2, glass, gem, or the like can be cited.
8) The flow velocity adjustor member 44A is enlarged in the upside and radial direction, and a cylindrical shaped falling space 90 is formed between the flow velocity adjustor member 44A and the drop tube 4. Construction is made so that cooling gas and the droplet 7 move within the falling space 90.
   The cross-sectional area of the falling space 90 becomes smaller toward the lower side so that flow velocity of the cooling gas can be equal to the free fall velocity of the droplet 7 as shown in FIG. 5. Because of this falling space 90, stable cooling gas flow can be formed. In addition, the top of the flow velocity adjustor member 44A is in close proximity to the bottom surface of the crucible 12, making it difficult to disturb the cooling gas by the rotation of the crucible 12. As for the rest, the same numerals are given to the same constitution elements with the aforementioned embodiment, and an explanation is omitted.
9) In the granulated crystal manufacturing device of FIG. 1, construction may be made to change the property of discharging droplet 7 by providing a gas regulation means for regulating the gas pressure of the upper side space of the crucible 12, and sealing to be nearly air proof between the peripheral surface of the crucible 12 and the cylindrical plate 36, and controlling the gas pressure.
10) The aforementioned embodiment is shown as just an example, and those skilled in the art will be able to make various modifications to various constructions of the aforementioned embodiment, and the present invention, include such modified embodiments.

## Claims

1. A drop tube type granulated crystal manufacturing device for creating a nearly spherical crystalline substance by solidifying while allowing a granular droplet made of an inorganic material to free fall within a drop tube, comprising:
a crucible provided at an upper end portion of said drop tube and rotatable around a vertical central axis, said crucible having a plurality of nozzles of a small diameter formed in a radial pattern relative to said vertical centeral axis at a periphery area thereof, and said crucible holding a melt of said inorganic material;
a rotary drive means for rotatively driving said crucible;
a heating means for heating said crucible and said inorganic material held in said crucible; and
a gas flow formation means for forming a flow of cooling gas inside said drop tube.

2. A drop tube type granulated crystal manufacturing device according to claim 1, wherein a post-phase heating means is provided for preventing instant cooling of droplets during free fall inside an upper end portion of said drop tube besides said heating means.

3. A drop tube type granulated crystal manufacturing device according to claim 1, wherein said gas flow formation means forms a cooling gas flow flowing from top to bottom inside said drop tube with a velocity which is nearly equal to a velocity of free falling droplets discharged from said nozzles.

4. A drop tube type granulated crystal manufacturing device according to claim 1, wherein a level detection means is provided for detecting a level of a melt within said crucible.

5. A drop tube type granulated crystal manufacturing device according to claim 1 or 2, wherein a rotating speed detection means is provided for detecting a rotating speed of said crucible.

6. A drop tube type granulated crystal manufacturing device according to any one of claim 1, 2, or 3, wherein said gas flow formation means comprises an external passage connected in parallel to said drop tube and a gas circulating pump.

7. A drop tube type granulated crystal manufacturing device according to claim 6, wherein a circular gas induction chamber which is connected to said external passage, for introducing cooling gas from said external passage, and a circular gas induction passage which communicates said gas induction chamber to an upper end portion of said drop tube, are provided.

8. A drop tube type granulated crystal manufacturing device according to any one of claim 1, 2, or 3, wherein a collecting unit is provided at the lower end of the drop tube for collecting said crystalline substance solidified in said drop tube.

9. A drop tube type granulated crystal manufacturing device according to any one of claim 1, 2, or 3, wherein a cooling gas passage inside said drop tube is formed so that a cross sectional area becomes smaller toward the downward side.

10. A drop tube type granulated crystal manufacturing device according to any one of claim 1, 2, or 3, wherein an inner peripheral surface of said drop tube is formed on a curved surface that becomes closer towards said vertical centeral axis toward the downward side.

11. A drop tube type granulated crystal manufacturing device according to any one of claim 1, 2, or 3, wherein a cooling device is provided for cooling said cooling gas in said gas flow formation means.

12. A drop tube type granulated crystal manufacturing device according to any one of claim 1, 2, or 3, wherein said inorganic material is a semiconductor.

13. A drop tube type granulated crystal manufacturing device according to any one of claim 1, 2, or 3, wherein said cooling gas is helium gas, argon gas, or mixed gas of these two.

14. A drop tube type granulated crystal manufacturing device according to any one of claim 1, 2, or 3, wherein said gas flow formation means comprises a pressure temperature adjusting means for adjusting a gas pressure and a temperature of said cooling gas inside said drop tube.

15. A drop tube type granulated crystal manufacturing device according to any one of claim 1, 2, or 3, wherein a raw material feeder is provided for sequentially supplying raw material to said crucible.

16. A drop tube type granulated crystal manufacturing device according to any one of claim 1, 2, or 3, wherein a control means capable of controlling a rotating speed of said crucible which is driven by said rotary drive means, is provided for changing a diameter of a droplet discharged from said crucible.

17. A drop tube type granulated crystal manufacturing device according to claim 16, wherein said control means controls said rotary drive means so as to discharge droplets from nozzles by increasing said rotating speed of said crucible pulsatively at intervals of pre-determined short time.

18. A drop tube type granulated crystal manufacturing device according to any one of claim 1, 2, or 3, wherein a pressurization means or vibration means capable of applying minute pressure to a melt within said crucible, and a pressurization control means for controlling said pressurization means or vibration means so that droplets are discharged from nozzles by applying minute pressure to said melt within said crucible at intervals of pre-determined short time by said pressurization means or said vibration means, is provided.

19. A granulated crystal manufacturing method for making a nearly spherical crystalline substance by solidification while allowing granular droplets of inorganic material to free fall inside a drop tube, comprising:
a first step for melting a raw material of inorganic material in a crucible while rotating said crucible provided at an upper end portion of said drop tube around a vertical axis;
a second step for allowing granular droplets to fall inside said drop tube by extracting said granular droplets to a horizontal or nearly horizontal direction by a centrifugal force, from a plurality of nozzles of a small diameter which are formed in a radial pattern relative to said vertical axis at a peripheral area of said crucible; and
a third step for solidifying said granular droplets during free fall inside said drop tube.

20. A granulated crystal manufacturing method according to claim 19, wherein a cooling gas flows inside said drop tube in the same direction as said granular droplets at a nearly equal velocity to a falling velocity of said granular droplets in said second step.

21. A granulated crystal manufacturing method according to claim 20, wherein said granular droplet is solidified by chilling said droplet until a super cooled state during the free falling and by making said droplet contact with a peripheral wall of said drop tube.
